# EUROPEAN PATENT APPLICATION

(11) **EP 4 692 967 A1**
(43) Date of publication of application: **11.02.2026**
(21) Application number: 23931748.0
(22) Date of filing: 27.09.2023
(51) Int. Cl.: G05B 23/02

(54) **SCENARIO TEST METHOD AND APPARATUS FOR DRIVING CONTROL SYSTEM, MEDIUM, AND DEVICE**

(30) Priority: 06.04.2023 CN 202310357080
(71) Applicant: Nanjing University, Nanjing, Jiangsu 210009 (CN)
(72) Inventor: BU, Lei, Nanjing, Jiangsu 210000 (CN); JIN, Yifan, Nanjing, Jiangsu 210000 (CN); LV, Yulong, Nanjing, Jiangsu 210000 (CN); WANG, Jiawan, Nanjing, Jiangsu 210000 (CN); LI, Xuandong, Nanjing, Jiangsu 210000 (CN)
(74) Representative: Casalonga
(86) International application number: PCT/CN2023/121923
(87) International publication number: WO 2024/207700

(57) **Abstract**

The present invention discloses a testing method and apparatus of a driving control system, a medium, and a device. According to the method, a state transition diagram is input, and then the test coverage of each state transition in the state transition diagram is gradually implemented on the basis of the state transition diagram and by means of loop iterative variation of a scenario sample. When the loop iterative variation is performed, a simulation output of the scenario sample is used as a reference, so that the iteration process can quickly converge to the corresponding state transition to achieve the goal of coverage testing. The present invention can intuitively test the processing capability and level of the driving control system for a driving environment, and exhibits high test efficiency.

## Description

### TECHNICAL FIELD

The present invention relates to simulation testing of a driving control system.

### BACKGROUND ART

Due to the need of analyzing and solving real driving scenarios, intelligent driving systems usually apply different route planning strategies to different real driving scenarios. Therefore, scenario modeling of intelligent driving systems is an effective means of analyzing the internal architecture of the system. Testing intelligent driving systems based on scenario construction is also a more accurate and objective solution. An intelligent driving system will treat a series of specific tasks during vehicle driving as a particular problem and handle the same in a corresponding manner. For example, particular problems such as turning left and turning right, which are specific driving scenarios. No matter at what time, if the vehicle is in a certain scenario, it will perform the same analysis, judgment and operations in the same state. Therefore, scenario modeling and scenario construction for intelligent driving systems is a feasible and effective solution. In this method, the test example is shown and presented as a simulated driving scenario. By converting the system codes into scenario models, the method can clearly show the entire timing process architecture of the system state, thereby performing analysis and testing on the architecture, and compared with direct code testing, it significantly reduces the complexity.

During the path planning and driving control process of an intelligent driving system, the vehicle, from its start, will solve various specific tasks required by the path based on various external information in each time period. For example, the navigation analysis determines that a certain intersection is inevitable to reach the destination. When the vehicle approaches the intersection, it determines the next task to be solved based on the current position is "how to pass the intersection."After passing the intersection, the vehicle will return to normal driving mode. The entire driving process is a sequential process, and at each time point the vehicle is in a particular state of processing the specific scenario at the moment. Therefore, the path planning module of the intelligent driving system can be modeled into a transition system model, and the transformation of the scenarios processed by the vehicle during driving can be abstracted into transformation of the vehicle states. The different logics of the vehicle in different states are the different means by which the vehicle processes different scenarios.

In the testing of intelligent driving systems, constructing a test set that can cover the majority of real driving scenarios is of great significance for testing the correctness of the codes. Testing more driving scenarios means that existing vulnerabilities are more likely to be discovered. Scenario modeling can help reduce the complexity of static analysis; however, analyzing large systems such as intelligent driving systems still requires a lot of manpower. To address this problem, fuzz testing is an effective testing method. It starts with random test examples, continuously tests the system through generated samples, and based on the feedback of the test results, generates new examples that are more likely to be effective than previous examples based on an effective fuzz testing strategy for further testing, thereby automating the entire process and achieving very good results with guidance of a good strategy.

### SUMMARY OF THE INVENTION

Problem to be solved by the present invention: testing and verification of a driving control system.

To solve the above problem, the solutions of the present invention are as follows:
A scenario testing method for a driving control system according to the present invention is associated with a simulation system loaded with a driving control system program; the driving control system program is instrumented with an instrumentation program instruction; the instrumentation program instruction is used to output a current control state of the driving control system and a value of the corresponding state attribute; the method comprises the steps of:
Step S1: Obtaining state control diagram information;
the state control diagram information comprises a set of control states, a set of state transitions, and a set of transition conditions;
the control state is used to represent the control state of the driving control system, and comprises a set of state attributes;
the state transition comprises a first control state and a second control state, and is used to indicate an action of the driving control system transitioning from the first control state to the second control state;
the transition condition corresponds to the state transition, and is used to indicate the condition that needs to be satisfied for the driving control system to transition from the first control state corresponding to the state transition to the second control state corresponding to the state transition, and is a state attribute Boolean expression;
the state attribute Boolean expression is a simple Boolean expression or a compound Boolean expression formed by compounding several simple Boolean expressions through conjunction operation and/or disjunction operation;
in the state attribute Boolean expression, the simple Boolean expression is a comparison expression about the size of the state attribute, and the state attribute comes from the first control state of the corresponding state transition;
Step S2: creating a set of initial scenario examples by randomly generating scenario sample information, and initializing second state transition set with a set of state transitions in the state control diagram information;
the scenario example comprises current scenario sample information; the current scenario sample information corresponds to the current scenario sample and is scenario sample information; in the initial set of scenario examples, the current scenario sample information is randomly generated scenario sample information;
Step S3: using the current scenario sample information of a scenario example in the scenario example set as the simulation data for simulating the real scenario, performing a simulation test on the driving control system program through the simulation system, and during the simulation test, collecting a log output of the driving control system program and an output of the instrumentation program instruction thereof to form a sample output sequence corresponding to the scenario example; the sample output sequence is a sequence consisting of sample outputs; the sample output including a control state and a value of the corresponding state attribute;
Step S4: extracting a control state transition in the simulation result output information sequence, and removing the control state transition, as a state transition, from the second state transition set; then determining whether to end the test based on whether the second state transition set is empty as a test end condition;
Step S5: Traversing the sample outputs in the sample output sequence, if the control state of the traversed sample output is the first control state of a state transition in the second state transition set, the scenario example corresponding to the sample output sequence, the sample output and the corresponding state transition are combined into expected scenario example state transition information, thereby obtaining an expected scenario example state transition information set;
the expected scenario example state transition information comprises a scenario sample, a sample output and a state transition; the sample output is a founder result output information;
Step S6: calculating the distance between the sample output and the state transition of each expected scenario example state transition information in the expected scenario example state transition information set, and extracting the scenario example corresponding to the state transition with the smallest distance between the sample output and the state transition from the expected scenario example state transition information set to form a seed corresponding to the state transition, thereby forming a seed set; the seed comprises the state transition and the current scenario sample information; the distance between the sample output and the state transition is the distance between the state attribute Boolean expression of the transition condition corresponding to the state transition and the sample output;
Step S7: performing variation processing on the current scenario sample information of each seed in the seed set to obtain updated current scenario sample information to form a scenario example set, and then returning to step S3;
in step S6, the distance between the state attribute Boolean expression and the sample output is calculated in the following way:
   for a simple Boolean expression, calculate the distance between the simple Boolean expression and the sample output;
   for conjunction operation, calculate the distance for each sub-item and calculate the sum of the sub-item distances;
   for the disjunction operation, calculate the distance for each sub-item and take the minimum value of the sub-item distances;
   the sub-item distance is the distance between the sub-state attribute Boolean expression of the state attribute Boolean expression and the sample output;
   the calculation of the distance between the simple Boolean expression and the sample output is to calculate the distance between the comparison expression regarding the size of the state attribute and the sample output, and the distance between the comparison expression F(op, sp, v)regarding hr size of the state attribute and the sample output is calculated using the following formula:
      if op is equal to or not equal to, then D(F(op,sp,v))=K; otherwise D(F(op,sp,v))=K+abs(v-out(sp));
      wherein op is the operator of the comparison expression regarding size, sp is the state attribute, v is the comparison value of the state attribute, F(op, sp, v) is expressed as the comparison expression regarding size: sp op v or v op sp, D(F(op, sp, v)) is the distance between the comparison expression regarding size and the sample output, K is a preset constant, abs is an absolute value function, and out(sp) is the value of the state attribute sp in the sample output.

Further, according to the scenario testing method of the driving control system of the present invention, in the step S8, performing a variation by randomly selecting a preset variation from a preset variation list according to a table of variation selection probability.

Further, according to the scenario testing method of the driving control system of the present invention, the scenario example further comprises seed scenario sample information and variation information; the seed scenario sample information corresponds to the seed scenario sample and is scenario sample information; the variation information is information regarding variation of the seed scenario sample to the current scenario sample, and comprises state transition, the distance between the sample output and the state transition, probabilities corresponding to each preset variation, and the preset variation selected for the variation;
in step S2, in the initial set of scenario examples, both the seed scenario sample information and the variation information are empty;
the seed further comprises the distance between the sample output and the state transition, the original seed scenario sample information and the original seed variation information;
in step S6, when forming the seed, the seed scenario sample information and the variation information in the scenario example are used, respectively, as the original seed scenario sample information and the original seed variation information of the seed;
in step S7, when variation of the current scenario sample information is performed, first determining whether the original seed scenario sample information of the seed is empty and whether the state transition is the same as the state transition in the original seed variation information; if the original seed scenario sample information is empty or the state transition of the seed is different from the state transition in the original seed variation information, initializing the table of variation selection probability so that the selection probabilities of the preset variations in the table of variation selection probability are the same; otherwise, extracting the probabilities corresponding to the preset variations in the original seed variation information of the seed to form a table of variation selection probability, and extracting the preset variation selected for a variation in the original seed variation information of the seed as the original variation, then adjusting the probability corresponding to the original variation in the table of variation selection probability according to the comparison between the distance between the sample output and state transition of the seed and the distance between the sample output and state transition in the original seed variation information, and finally randomly selecting a preset variation from the preset variation list according to the adjusted table of variation selection probability, and performing the variation.

Further, according to the scenario testing method of the driving control system of the present invention, the preset variations comprise: randomly changing the starting and ending points of a vehicle, randomly changing the signal light sequence, randomly changing the NPC vehicles, or adjusting the interference intensity of the NPC around the vehicle under control.

According to a scenario testing apparatus of a driving control system of the present invention, the device is connected to a simulation system loaded with a driving control system program; the driving control system program is instrumented with an instrumentation program instruction; the instrumentation program instruction is used to output a current control state of the driving control system and a value of the corresponding state attribute; the apparatus comprises the following modules:
a module M1 for obtaining state control diagram information;
the state control diagram information comprises a set of control states, a set of state transitions, and a set of transition conditions;
the control state is used to represent the control state of the driving control system, and comprises a set of state attributes;
the state transition comprises a first control state and a second control state, and is used to indicate an action of the driving control system transitioning from the first control state to the second control state;
the transition condition corresponds to the state transition, and is used to indicate the condition that needs to be satisfied for the driving control system to transition from the first control state corresponding to the state transition to the second control state corresponding to the state transition, and is a state attribute Boolean expression;
the state attribute Boolean expression is a simple Boolean expression or a compound Boolean expression formed by compounding several simple Boolean expressions through conjunction operation and/or disjunction operation;
in the state attribute Boolean expression, the simple Boolean expression is a comparison expression about the size of the state attribute, and the state attribute comes from the first control state of the corresponding state transition;
a module M2 for creating a set of initial scenario examples by randomly generating scenario sample information, and initializing second state transition set with a set of state transitions in the state control diagram information;
the scenario example comprises current scenario sample information; the current scenario sample information corresponds to the current scenario sample and is scenario sample information; in the initial set of scenario examples, the current scenario sample information is randomly generated scenario sample information;
a module M3 for using the current scenario sample information of a scenario example in the scenario example set as the simulation data for simulating the real scenario, performing a simulation test on the driving control system program through the simulation system, and during the simulation test, collecting a log output of the driving control system program and an output of the instrumentation program instruction thereof to form a sample output sequence corresponding to the scenario example; the sample output sequence is a sequence consisting of sample outputs; the sample output comprising control state and a value of the corresponding state attribute;
a module M4 for extracting a control state transition in the simulation result output information sequence, and removing the control state transition, as a state transition, from the second state transition set; then determining whether to end the test based on whether the second state transition set is empty as a test end condition;
a module M5 for traversing the sample outputs in the sample output sequence, if the control state of the traversed sample output is the first control state of a state transition in the second state transition set, the scenario example corresponding to the sample output sequence, the sample output and the corresponding state transition are combined into expected scenario example state transition information, thereby obtaining an expected scenario example state transition information set;
the expected scenario example state transition information comprises a scenario sample, a sample output and a state transition; the sample output is a founder result output information;
a module M6 for calculating the distance between the sample output and the state transition of each expected scenario example state transition information in the expected scenario example state transition information set, and extracting the scenario example corresponding to the state transition with the smallest distance between the sample output and the state transition from the expected scenario example state transition information set to form a seed corresponding to the state transition, thereby forming a seed set; the seed comprises the state transition and the current scenario sample information;
the distance between the sample output and the state transition is the distance between the state attribute Boolean expression of the transition condition corresponding to the state transition and the sample output;
a module M7 for performing variation processing on the current scenario sample information of each seed in the seed set to obtain updated current scenario sample information to form a scenario example set, and then returning to the module M3;
In the module M6, the distance between the state attribute Boolean expression and the sample output is calculated in the following way:
   for a simple Boolean expression, calculate the distance between the simple Boolean expression and the sample output;
   for conjunction operation, calculate the distance for each sub-item and calculate the sum of the sub-item distances;
   for the disjunction operation, calculate the distance for each sub-item and take the minimum value of the sub-item distances;
   the sub-item distance is the distance between the sub-state attribute Boolean expression of the state attribute Boolean expression and the sample output;
   the calculation of the distance between the simple Boolean expression and the sample output is to calculate the distance between the comparison expression regarding the size of the state attribute and the sample output, and the distance between the comparison expression F(op, sp, v) regarding hr size of the state attribute and the sample output is calculated using the following formula:
      if op is equal to or not equal to, then D(F(op,sp,v))=K; otherwise D(F(op,sp,v))=K+abs(v-out(sp));
      wherein op is the operator of the comparison expression regarding size, sp is the state attribute, v is the comparison value of the state attribute, F(op, sp, v) is expressed as the comparison expression regarding size: sp op v or v op sp, D(F(op, sp, v)) is the distance between the comparison expression regarding size and the sample output, K is a preset constant, abs is an absolute value function, and out(sp) is the value of the state attribute sp in the sample output.

According to the scenario testing apparatus for a driving control system according to claim 1, in the module M8, a preset variation is randomly selected from a preset variation list for the variation according to a table of variation selection probability.

Further, the scenario testing apparatus for the driving control system according to the present invention, characterized in that the scenario example further comprises seed scenario sample information and variation information; the seed scenario sample information corresponds to the seed scenario sample and is scenario sample information; the variation information is information regarding a variation of the seed scenario sample to the current scenario sample, and comprises state transition, the distance between the sample output and the state transition, probabilities corresponding to each preset variation, and the preset variation selected for the variation;
in the module M2, in the initial set of scenario examples, both the seed scenario sample information and the variation information are empty;
the seed further comprises the distance between the sample output and the state transition, the original seed scenario sample information and the original seed variation information;
in the module M6, when forming the seed, the seed scenario sample information and the variation information in the scenario example are used, respectively, as the original seed scenario sample information and the original seed variation information of the seed;
in the module M7, when a variation of the current scenario sample information is performed, first determining whether the original seed scenario sample information of the seed is empty and whether the state transition is the same as the state transition in the original seed variation information; if the original seed scenario sample information is empty or the state transition of the seed is different from the state transition in the original seed variation information, initializing the table of variation selection probability so that the selection probabilities of the preset variations in the table of variation selection probability are the same; otherwise, extracting the probabilities corresponding to the preset variations in the original seed variation information of the seed to form a table of variation selection probability, and extracting the preset variation selected for a variation in the original seed variation information of the seed as the original variation, then adjusting the probability corresponding to the original variation in the table of variation selection probability according to the comparison between the distance between the sample output and state transition of the seed and the distance between the sample output and state transition in the original seed variation information, and finally randomly selecting a preset variation from the preset variation list according to the adjusted table of variation selection probability, and performing the variation.

Further, according to the scenario testing apparatus of the driving control system of the present invention, the preset variations comprise: randomly changing the starting and ending points of the vehicle, randomly changing the signal light sequence, randomly changing the NPC vehicles, or adjusting the interference intensity of the NPC around the vehicle under control.

According to a medium of the present invention, the medium stores a program instruction set readable by a machine, and when the program instruction set stored in the medium is read and executed by the machine, the above-mentioned scenario testing method of the driving control system can be implemented.

Further, according to a device of the present invention; the device comprises a processor and a memory; a program instruction set is stored in the memory, and when the program instruction set stored in the memory is loaded and executed by the processor, the above-mentioned scenario testing method of the driving control system can be implemented.

The technical effects of the present invention are as follows:
The present invention realizes the test target of state transition test coverage by creating scenario parameters, and can intuitively test the processing capability and level of the driving control system for driving environment. The present invention exhibits high test efficiency.

The present invention uses the simulation output of the scenario sample as a reference when performing loop iterative variation, so that the iteration process can quickly converge to the corresponding state transition to achieve the goal of coverage testing, and the testing efficiency is high.

### BRIEF DESCRIPTION OF THE DRAWINGS

FIG. 1 is a test control flow chart of an embodiment of the present invention.
FIG. 2 is a schematic diagram of the structural connection of an embodiment of a test control system of the present invention.
FIG. 3 is a schematic structural diagram of an embodiment of the device of the present invention.

### DETAILED DESCRIPTION OF THE INVENTION

The present invention will be further described in detail below with reference to the accompanying drawings.

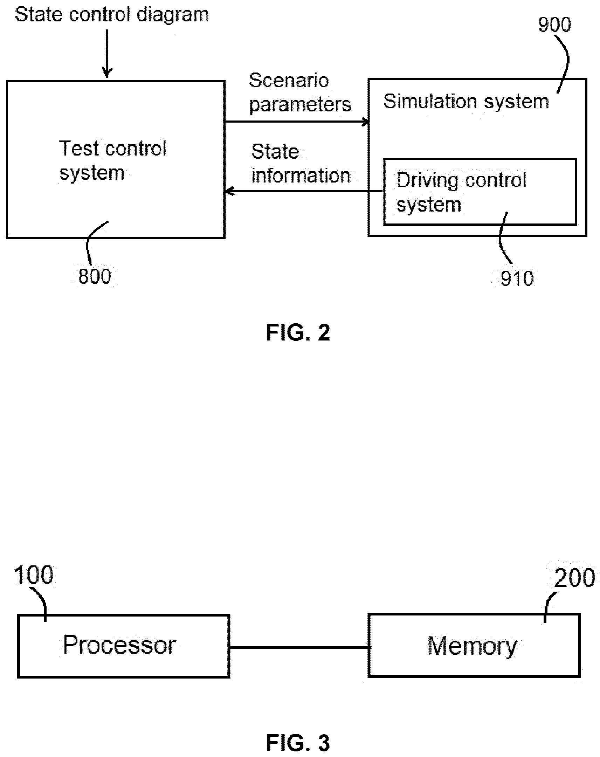

Referring to FIG. 2, the embodiment relates to a test control system 800.The test control system 800 is connected to a simulation system 900.The simulation system 900 is loaded with a driving control system 910.The test control system 800, the simulation system 900, and the driving control system 910 are all implemented by devices executing computer programs. The input of the test control system 800 is a state control diagram. By executing a computer program, scenario parameters are generated according to the state control diagram and input into the simulation system 910. The simulation system 900 receives the scenario parameters by executing a computer program, and then generates a simulated driving environment for the driving control system 910 according to the scenario parameters. By executing a computer program, the driving control system 910 adjusts the vehicle driving according to the driving environment simulated by the simulation system 900, and returns status information to the test control system 800 in real time when adjusting the vehicle driving. The test control system 800 performs test coverage analysis based on the returned status information. If the test coverage objective is achieved, the simulation test process is completed; if not, new scenario parameters are generated and input into the simulation system 910 for the next simulation step. The test control system 800, the simulation system 900, and the driving control system 910 may be configured on the same device or on different devices. If configured on multiple devices, these devices should be connected through a network. FIG. 3 illustrates a device for configuring the test control system 800. Referring to FIG. 2, the device is specifically an electronic device, and, includes at least a processor 100 and a memory 200 connected to each other. The processor 100 is typically a general-purpose computer processor capable of executing computer program instructions, and the memory 200 is typically a medium that can store data without loss after power off, and includes without limitation to disks, tapes, flash memory, etc. This medium is also the medium referred to above in the present invention. The memory 200 is generally used to store computer program instruction sets and data. The processor 100 implements its corresponding automation function by loading the program instruction set stored in the memory 200.Specifically in this embodiment, the processor 100 implements the above-mentioned test control system 800 by loading and executing the program instruction set stored in the memory 200.When the processor 100 executes the program instruction set to implement the test control system 800, the processing by the processor 100 is the scenario test method of the driving control system of the present invention. Similarly, the driving control system 910 is implemented by a machine or device executing the driving control system program of the present invention, and the simulation system 900 is implemented by a machine or device executing the simulator program. Simulator programs can be, such as LGSVL, Carla, etc. Driving control system programs can be, such as Apollo, Autoware, etc. Specifically, in this embodiment, the simulator program is a LGSVL simulator, and the driving control system program is Baidu Apollo 6.0. More specifically, the driving control system of this embodiment is the control planning module of autonomous driving system Baidu Apollo 6.0. To achieve the testing objective of the present invention, in this embodiment, instrumentation is carried out on the control planning module of Baidu Apollo 6.0, that is, instrumentation program instructions are inserted into the control planning module of Baidu Apollo 6.0. In this embodiment, the instrumentation program instructions are combined with the log output of Baidu Apollo 6.0, so that the instrumentation program instructions can output status information.

In FIG. 2, the state control diagram input to the test control system 800 corresponds to the state control diagram information of the scenario test method of the driving control system of the present invention; the scenario parameters output by the test control system 800 correspond to the scenario sample information of the scenario test method of the driving control system of the present invention; the status information interactively received by the test control system 800 corresponds to the current control status of the driving control system 910 and the corresponding status attribute value of the scenario test method of the driving control system of the present invention.

The state control diagram is a directed diagram consisting of nodes and directed edges. A directed edge connects two nodes and points from one node to another. The front node is the starting node of the directed edge, and the rear node is the ending node of the directed edge. Corresponding to the state control diagram information, the nodes correspond to the control states, the directed edges correspond to the state transitions and the transition conditions corresponding to the state transitions. Specifically, the state control diagram information includes a set of control states, a set of state transitions, and a set of transition conditions. The control states are used to represent the control states of the driving control system, and include a set of control state identification codes and state attributes. In simple terms, the state control diagram information of the present invention is a directed diagram with control states as nodes and state transitions as edges.

State attributes are parameters used by the vehicle driving control system to characterize the current control state, including system parameters and external environment parameters. The system parameters include vehicle speed, acceleration, throttle size, brake strength, steering angle of steering wheel, etc.; external environment parameters are used to characterize the data sensed by vehicle sensors, such as traffic light color, surrounding vehicles and their positions, etc. Since there are many kinds of state attributes, and many kinds of state attributes are also needed to characterize the control state, but not all of them are needed, therefore, the state attributes of the control state need to be represented by a set, that is, a set of state attributes. Furthermore, the sets of state attributes of different control states are usually different, but they may also be the same. It should be further pointed out that the state attributes in a control state are the names of the state attributes rather than the values of the state attributes.

The state transition includes a first control state and a second control state, and is used to indicate the action of the driving control system transitioning from the first control state to the second control state. The first control state and the second control state are both the aforementioned control states, wherein the first control state corresponds to the starting node of the directed edge, or may be referred to as the starting control state; the second control state corresponds to the ending node of the directed edge, or may be referred to as the ending control state. In the state transition, the first control state and the second control state are usually represented by control state identification codes. A transition condition corresponds to a state transition, and is used to indicate the condition that needs to be satisfied for the driving control system to transit from the first control state corresponding to the state transition to the second control state corresponding to the state transition. The transition condition is a state attribute Boolean expression. It should be pointed out that, in the implementation of this embodiment, state transition information is used to represent the state transition and the transition condition. The state transition information includes a first control state, a second control state, and a state attribute Boolean expression. The reason why the present invention divides the state transition information into state transition and transition condition is only for the convenience of subsequent description.

The state attribute Boolean expression is a simple Boolean expression or a compound Boolean expression formed by compounding several simple Boolean expressions through conjunction operation and/or disjunction operation. In the state attribute Boolean expression, the simple Boolean expression is a size comparison expression with regard to the state attribute, and the state attribute comes from the first control state of the corresponding state transition. Here, the size comparison expression can be expressed as F(op, sp, v), wherein op is the operator of the size comparison expression, sp is the state attribute, and v is the comparison value of the state attribute. In a particular actual expression, the size comparison expression F(op, sp, v) is equivalent to sp op v, or equivalent to v op spate operator op of the size comparison expression includes six tupes, namely, equal, not equal, greater than, greater than or equal to, less than, and less than or equal to. The corresponding specific size comparison expressions F(op, sp, v) are respectively 6 cases below:
sp==v;
sp!=v;
sp>v;
sp> = v;
sp<v;
sp<=v.

The compound Boolean expression can be expressed as:
Conjunction form, b_1 Λ b_2 Λ ... Λ b_n, or
Disjunction form, b_1 V b_2 V ... V b_n.

In the compound Boolean expression, b_1, b_2, ..., b_n are sub-items or sub-expressions of the compound Boolean expression; the sub-items or sub-expressions of the compound Boolean expression can be simple Boolean expressions, or compound Boolean expressions compounded by simple Boolean expressions.

In addition, it should be pointed out that, in the implementation of this embodiment, the control state generally only uses the state identification code, and the state attribute of the control state is actually represented by the state transition information. Specifically, for a certain control state, the state attributes come from the state attribute Boolean expressions of each state transition information of the control state as the first control state, and the state attributes relating to the state attribute Boolean expressions of each state transition information constitute the state attribute set of the control state. One skilled in the art would understand that the particular implementation of this embodiment described above is different from the aforementioned implementation of the present invention merely in that the ways of expressing the data structure are different, and they are essentially the same.

Further, it should be pointed out that the aforementioned state control diagram or state control diagram information corresponds to a transition system model based on scenario classification. The model is obtained through code analysis, code abstraction and modeling of the planning and control module of the intelligent driving system that is based on scenario classification. Specifically, in this embodiment, the models are obtained through code abstraction and modeling of the planning control module of Baidu Apollo 6.0. The "obtaining state control diagram information" in the aforementioned step S1 indicates that the state control diagram information is the input of the scenario testing method of the driving control system of the present invention. With respect to how to obtain the state control diagram information or the way used to obtain it and the way of modeling are not within the scope of the present invention and thus need not be elaborated.

Additionally, since the aforementioned instrumentation of the driving control system program is established on the migration system model, the state information output by the aforementioned instrumentation program instruction corresponds to the state control diagram information. The state information includes the control state and the value of the state attribute. That is, the instrumentation program instruction is used to output the current control state of the driving control system and the value of the corresponding state attribute. Furthermore, the value of the state attribute here needs to correspond to the name of the state attribute. Therefore, in the implementation of this embodiment, the value of the state attribute is represented by a 2-tuple of the state attribute and the value of the state attribute. Additionally, there are multiple state attributes corresponding to a control state, therefore, there are also multiple values of state attributes in the state information. Furthermore, for convenience of representation, the control state of the state information is represented by a control state identification code.

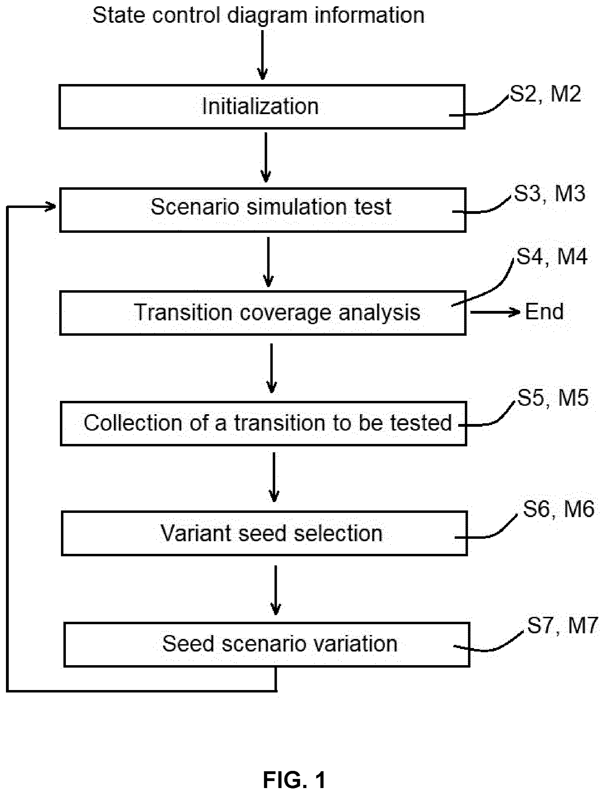

Referring to Fig.1 , the scenario testing method of a driving control system of the present invention comprises steps of initialing, scenario simulation testing, transition coverage analyzing, to-be-tested transition collecting, variant seed optimizing, and seed scenario variation, wherein the steps of initialing, scenario simulation testing, transition coverage analyzing, to-be-tested transition collecting, variant seed optimizing, and seed scenario variation are a process of loop iteration. The termination condition of the loop iteration depends on the coverage test analysis of the state transition in the step of transition coverage analysis step.

The initialization step, that is, the aforementioned step S2, creates an initial scenario example set by randomly generating scenario sample information, and initializes the second state transition set with the set of state transitions in the state control diagram information. In simple terms, this step initializes the scenario example set and the second state transition set. The scenario example set is a set of scenario examples. Scenario examples are used to represent scenario samples. The scenario sample information is the scenario parameters input by the aforementioned test control system 800 to the simulation system 900, which is equivalent to a test case and is a collection of scenario parameters, including, for example, road layout data, the starting and ending positions of the vehicle, the locations of traffic lights and the sequence of traffic light transitions, NPCs around the road and the vehicle, etc. With respect to which scenario parameters are included in the scenario sample information, it depends on the driving environment that needs to be simulated. The second state transition set is used to store untested state transitions. During initialization, all state transitions in the state control diagram information have not been tested, and therefore, during initialization, the second state transition set is a copy of the set of state transitions in the state control diagram information. In this embodiment, in order to facilitate the variation of subsequent scenario samples, the scenario samples in the scenario example are divided into current scenario sample and seed scenario sample. More specifically, the scenario example includes current scenario sample information, seed scenario sample information and variation information. The current scenario sample information and the seed scenario sample information correspond to the current scenario sample and the seed scenario sample respectively, and both are scenario sample information. In the initial set of scenario examples, the current scenario sample information is randomly generated scenario sample information, and the seed scenario sample information and the variation information are empty. In subsequent processing, the current scenario sample information of the scenario example is obtained by variation of the seed scenario sample information of the scenario example. The variation information stores the information regarding the variation of the seed scenario sample to the current scenario sample, including the state transition, the distance between the sample output and the state transition, the probability corresponding to each preset way of variation, and the preset way of variation selected for the variation. Additionally, the randomly generated scenario sample information here is specifically that each scenario parameter of the scenario sample information randomly generates a specific scenario parameter.

The scenario simulation test step, that is, the aforementioned step S3, uses the current scenario sample information of a scenario example in the scenario example set as the simulation data for simulating the real scenario, and performs simulation test on the driving control system program through the simulation system, and during the simulation test, collects the log output of the driving control system program and the output of its instrumentation program instructions to form a sample output sequence corresponding to the scenario example. The sample output sequence is a sequence consisting of sample outputs. The sample outputs include control states and the corresponding values of the state attributes. Or, it can be said that the control states output by the aforementioned instrumentation program instructions and the corresponding values of the state attributes are the sample outputs referred to in the present invention.

This step corresponds to the aforementioned test control system 800 inputting the current scenario sample information as scenario parameters into the simulation system 900, the simulation system 900 simulates a simulated driving environment for the driving control system 910 according to the scenario parameters, and the driving control system 910 adjusts the vehicle driving according to the driving environment simulated by the simulation system 900. With respect to how the simulation system 900 simulates the corresponding simulated driving environment according to the scenario parameters, and how the driving control system 910 adjusts the vehicle driving control according to the driving environment are not within the scope of the present invention and need not be elaborated. Additionally, it should be pointed out that the sample output sequence here corresponds to the scenario sample information, and there are multiple scenario sample information for the simulation testing in this step. Correspondingly, there are also multiple sample output sequences, that is, this step actually outputs a set of sample output sequences.

The transition coverage analysis step, that is, the aforementioned step S4, extracts the control state transition from the simulation result output information sequence, and removes the control state transition, as a state transition, from the second state transition set; then determines whether to end the test based on the test end condition, i.e., whether the second state transition set is empty. The control state transition here is a transition from one control state to another control state, which is equivalent to the aforementioned state transition. Here, the second state transition set is empty indicates that all state transitions have been tested. In the implementation of this embodiment, there are two test end conditions for determining whether to end the test: the first is whether the second state transition set is empty, and the second is whether the number of loop iterations exceeds a preset threshold. Specifically, if the second state transition set is empty or the number of loop iterations exceeds a preset threshold, the test process is over. Additionally, the above test end condition implies that one of the test objectives of the scenario test method of the driving control system of the present invention is to achieve coverage test of all state transitions.

The step of collecting the transition to be tested, that is, the aforementioned step S5, traverses the sample outputs in the sample output sequence. If the control state of the traversed sample output is the first control state of a state transition in the second state transition set, the scenario example corresponding to the sample output sequence, the sample output and the corresponding state transition are combined into the expected scenario example state transition information, thereby obtaining an expected scenario example state transition information set. The expected transition information of the scenario example state includes the scenario example, sample output and state transition. This step simply determines the state transition of the target to be tested for the next iteration.

Assume that in the state control diagram information, the control states are: c1, c2, c3, c4, c5, c6, and the corresponding state transitions are as follows: c1->c2, c1->c3, c1->c4, c2->c3, c2->c5, c2->c6, c3->c4, c3->c6, c4->c5, c4->c6, c5->c6.It is also assumed that there are four sample output sequences outputted in the aforementioned step S3, namely ss1, ss2, ss3, and ss4. Among them, the sample outputs in the sample output sequence ss1 are ss1_c1 and ss1_c2, the sample outputs in the sample output sequence ss2 are ss2_c1 and ss2_c3, the sample outputs in the sample output sequence ss3 are ss3_c1 and ss3_c4, and the sample outputs in the sample output sequence ss4 are ss4_c1, ss4_c2, and ss4_c3. Among them, sample outputs ss1_c1, ss2_c1, ss3_c1, and ss4_c1 all correspond to control state c1, sample outputs ss1_c2 and ss4_c2 correspond to control state c2, sample output ss2_c3 corresponds to control state c3, and sample output ss3_c4 corresponds to control state c4.That is to say, the sample output sequence ss1 includes control states c1 and c2, and the corresponding control state transition isc1->c2; the sample output sequence ss2 includes control states c1 and c3, and the corresponding control state transition is c1->c3; the sample output sequence ss3 includes control states c1 and c4, and the corresponding control state transition is c1->c4; the sample output sequence ss4 includes control states c1, c2 and c3, and the corresponding control state transitions are c1->c2 and c2->c3.That is to say, the tests for the state transitions c1->c2, c1->c3, c2->c3 and c1->c4 have been completed. After processing in step S4, the remaining state transitions in the second state transition set are: c2->c5, c2->c6, c3->c4, c3->c6, c4->c5, c4->c6, and c5->c6.

Therefore, in this step, the traversal of the sample outputs in the sample output sequence ss1 can obtain the corresponding control states c1 and c2. The state transitions in the second state transition set whose first control state is c1 or c2 are c2->c5 and c2->c6.The sample output corresponding to the first control state c2 in the state transitions c2->c5, c2->c6 is ss1_c2.There are two expected scenario example state transition information that can be formed therewith: espt_1 and espt_2, wherein espt_1 = {scenario example corresponding to sample output sequence ss1, sample output ss1_c2, state transition c2->c5}, espt_2 = {scenario example corresponding to sample output sequence ss1, sample output ss1_c2, state transition c2->c6}.

Traversing of the sample outputs in the sample output sequence ss2can obtain corresponding control states c1 and c3,the state transitions in the second state transition set whose first control state is c1 or c3 are c3->c4, c3->c6, and the sample output corresponding to the first control state c3 in the state transitions c3->c4, c3->c6 is ss2_c3. There are two expected scenario example state transition information that can be formed therewith: espt_3 and espt_4, wherein espt_3 = {scenario example corresponding to sample output sequence ss2, sample output ss2_c3, state transition c3->c4}, espt_ 4 = {scenario example corresponding to sample output sequence ss2, sample output ss2_c3, state transition c3->c6}.

Traversing of the sample outputs in the sample output sequence ss3can obtain corresponding control states c1 and c4, the state transitions in the second state transition set whose first control state is c1 or c4 are c4->c5, c4->c6, and the sample output corresponding to the first control state c4 in the state transitions c4->c5, c4->c6 is ss3_c4. There are two expected scenario example state transition information that can be formed therewith: espt_5 and espt_6, wherein espt_5 = {scenario example corresponding to sample output sequence ss3, sample output ss3_c4, state transition c4->c5}, espt_6 = {scenario example corresponding to sample output sequence ss3, sample output ss3_c4, state transition c4->c6}.

Traversing of the sample outputs in the sample output sequence ss4can obtain corresponding control states c1, c2 and c3, the state transitions in the second state transition set whose first control state is c1 or c2 or c3 are c2->c5, c2->c6 and c3->c4, c3->c6, wherein the sample output corresponding to the first control state c2 in the state transitions c2->c5, c2->c6 is ss4_c2; the sample output corresponding to the first control state c3 in the state transitions c3->c4, c3->c6 is ss4_c3.There are four expected scenario example state transition information that can be formed therewith: espt_7, espt8, espt9 and espt_10, wherein espt_7 = {scenario example corresponding to sample output sequence ss4, sample output ss4_c2, state transition c2->c5}, espt_8 = {scenario example corresponding to sample output sequence ss4, sample output ss4_c2, state transition c2->c6}, espt_9 = {scenario example corresponding to sample output sequence ss4, sample output ss4_c3, state transition c3->c4}, and espt_10 = {scenario example corresponding to sample output sequence ss4, sample output ss4_c3, state transition c3->c6}.

Therefore, the set of expected scenario sample state transition information that can be obtained according to step S5 is: {espt_1, espt_2, espt_3, espt_4, espt_5, espt_6, espt_7, espt_8, espt_9, espt_10}.The set of expected scenario sample state transition information includes the state transitions of the target to be tested in the next iterations: c2->c5, c2->c6, c3->c4, c3->c6, c4->c5 and c4->c6.

The variant seed selection step, that is, the aforementioned step S6, calculates the distance between the sample output and the state transition of each expected scenario example state transition information in the expected scenario example state transition information set, and extracts the scenario example corresponding to the state transition with the smallest distance between the sample output and the state transition from the expected scenario example state transition information set to form a seed corresponding to the state transition, thereby forming a seed set; the seed comprises the state transition and the current scenario sample information. According to the example in the aforementioned step S5, the number of state transitions included in the expected scenario example state transition information set output in step S5 is different from the number of elements in the expected scenario example state transition information set. That is to say, in the state transitions of the target to be tested in the next iteration outputted in step S5, each state transition may correspond to multiple expected scenario example state transition information. For example, according to the example of the aforementioned step S5, the scenario example state transition information corresponding to the state transition c2->c5 is: espt_1 and espt_7.In simple terms, the purpose of this step is, in the expected scenario example state transition information set, to select a preferred one from multiple expected scenario example state transition information corresponding to a state transition as a seed for variation. For example, from the scenario examples of the two expected scenario example state transition information espt_1 and espt_7 corresponding to the aforementioned state transition c2->c5, select one of them as the seed. The seed may be the scenario example corresponding to the sample output sequence ss1 or the scenario example corresponding to the sample output sequence ss4.The criterion for selecting a seed is based on the distance between the sample output and the state transition. For expected scenario example state transition information espt_1, it is the distance between the sample output ss1_c2 and the state transition c2->c5;for expected scenario example state transition information espt_7, it is the distance between the sample output ss4_c2 and the state transition c2->c5.The distance between the sample output and the state transition is the distance between the state attribute Boolean expression of the transition condition corresponding to the state transition and the sample output. The distance between the state attribute Boolean expression and the sample output is calculated as follows: for simple Boolean expressions, calculate the distance between the simple Boolean expression and the sample output; for conjunction operation, calculate each sub-item distance and then sum the sub-item distances up; for disjunction operation, calculate each sub-item distance and then take the minimum value of the sub-item distances; wherein the sub-item distance is the distance between the sub-state attribute Boolean expression of the state attribute Boolean expression and the sample output.

According to the above calculation methods, for a complex state attribute Boolean expression, its distance from the sample output can be obtained by a recursive calculation, as the sub-state attribute Boolean expression of the state attribute Boolean expression is also a state attribute Boolean expression. Furthermore, according to the foregoing, the simple Boolean expression constituting the state attribute Boolean expression is a comparison expression regarding the size of a state attribute, which can be expressed as F(op, sp, v).Therefore, calculating the distance between a simple Boolean expression and a sample output is to calculate the distance between the comparison expression F(op, sp, v) regarding the size of state attribute and the sample output. The distance between F(op,sp,v) and the sample output is calculated as follows: If op is equal to or not equal to, then D(F(op,sp,v))=K; otherwise D(F(op,sp,v))=K+abs(v-out(sp)), wherein D(F(op,sp,v)) is the distance between the size comparison expression and the sample output, K is a preset constant, abs is an absolute value function, and out(sp) is the value of the state attribute sp in the sample output.

Additionally, in this embodiment, the seed includes state transition, current scenario sample information, original seed scenario sample information, original seed variation information, and the distance between the sample output and the state transition, wherein the state transition of the seed comes from the expected scenario example state transition information, and the current scenario sample information of the seed, original seed scenario sample information and original seed variation information come from, respectively, the current scenario sample information, seed scenario sample information and variation information of the scenario example of the expected scenario example state transition information. The distance between the sample output and the state transition is the distance between the sample output and the state transition in the expected scenario example state transition information.

The seed scenario variation step, that is, the aforementioned step S7, performs variation processing on the current scenario sample information of each seed in the seed set to obtain updated current scenario sample information to form a scenario example set, and then returns to step S3.

There are many ways to carry out variation of the current scenario sample information of the seed. The simplest way is, for example, randomly selecting a scenario parameter of the current scenario sample information, and randomly generating a specific scenario parameter value for the scenario parameter. Another simple way is to perform random variation on a specific item, such as changing the starting and ending points of the vehicle, changing the signal light sequence, changing the NPC vehicles, or adjusting the interference intensity of the NPCs around vehicle under control, etc.

Yet another simple implementation is to preset some variations, and then randomly select one of these preset variations to carry out the variation. The preset variations can be, for example, randomly changing the starting and ending points of the vehicle, randomly changing the traffic light sequence, randomly changing the NPC vehicles, or adjusting the interference intensity of the NPCs around the vehicle under control, etc. Of course, a corresponding probability may be preset for each preset variation, thereby creating a table of variation selection probability, so that when randomly selecting a preset variation, the selection can be made based on the table of variation selection probability.

Apparently, the overall test efficiency is low with all these three implementations. Furthermore, for these simple implementations, the variation of the current scenario sample information does not utilize the original seed scenario sample information, the original seed variation information and the distance between the sample output and the state transition contained in the seed. Therefore, such information is non-essential information in these simple implementations. Similarly, the aforementioned scenario example only needs the current scenario sample information, and the seed scenario sample information and the variation information in the scenario example can be omitted.

In order to improve the test efficiency and to ensure the new current scenario sample information generated by the variation can achieve the purpose of test coverage of the corresponding state transition, the variation of the current scenario sample information of the seed in this embodiment is carried out by the following steps:
Step S71: First, determining whether the original seed scenario sample information of the seed is empty and whether the state transition is the same as the state transition in the original seed variation information; if the original seed scenario sample information is empty or the state transition of the seed is different from the state transition in the original seed variation information, going to step S72, otherwise going to step S73;
Step S72: Initializing the table of variation selection probability so that the selection probabilities of the preset variations in the table of variation selection probability are the same, and then randomly selecting one preset variation from the preset variations according to the table of variation selection probability and performing the variation;
Step S73: extracting the probabilities corresponding to the preset variations in the original seed variation information of the seed to form a table of variation selection probability, and extracting the preset variation selected for a variation in the original seed variation information of the seed as the original variation;
Step S74: Adjusting the probability corresponding to the original variation in the table of variation selection probability according to the comparison between the distance between the sample output and state transition of the seed and the distance between the sample output and state transition in the original seed variation information: if the distance between the sample output and state transition of the seed is greater, then decrease the probability corresponding to the original variation; otherwise, increase the probability corresponding to the variation.

Step S75: randomly selecting a preset variation from the preset variation list according to the adjusted table of variation selection probability, and performing the variation.

In simple terms, the above steps S71 to S75 are an optimization of the aforementioned second simple implementation. That is to say, in the implementation of this embodiment, the variation of the current scenario sample information of the seed is also performed by subsequently randomly selecting a preset variation from the preset variation list according to the table of variation selection probability. However, in the implementation of this embodiment, iterative optimization adjustment of the variation selection probability is performed.

Additionally, the preset variations in this embodiment comprise randomly changing the starting and ending points of the vehicle, randomly changing the sequence of traffic lights, randomly changing NPC vehicles, or adjusting the interference intensity of NPCs around the vehicle under control, etc. One skilled in the art should understand that the preset variations may also be based on the scenario parameter itself. For example, randomly increasing the scenario parameter value is a preset variation, and randomly decreasing the scenario parameter value is another preset variation. Accordingly, number N scenario parameters in the scenario sample information correspond to number 2N preset variations.

Furthermore, in the scenario example generated by variation in this embodiment, the current scenario sample information is the new current scenario sample information generated by the variation, the seed scenario sample information is the current scenario sample information of the corresponding seed, and the variation information is the variation parameter information recorded when the new current scenario sample information is generated by variation of the current scenario sample information of the seed.

Additionally, it should be pointed out that in this embodiment, by inserting Instrumentation program instructions into the original driving control system program through manual instrumentation, the driving control system can output the current control state and the value of the corresponding state attribute. If, upon execution, the original driving control system program can output the current control state of the driving control system and the value of the corresponding state attribute, it can be regarded as the original driving control system program is instrumented with the instrumentation program instructions referred to in the present invention.

Furthermore, in this embodiment, in order to facilitate the subsequent regression test, all the scenario sample information of the tests that have been completed is retained and output.

Additionally, it should be noted that the modules described in the present invention are virtual devices corresponding to the steps of the method, and will not be described in detail.

## Claims

1. A scenario testing method for a driving control system, the method is associated with a simulation system loaded with a driving control system program, **characterized in that** the driving control system program is instrumented with an instrumentation program instruction; the instrumentation program instruction is used to output a current control state of the driving control system and a value of the corresponding state attribute; the method comprises the steps of:
Step S1: Obtaining state control diagram information;
the state control diagram information comprises a set of control states, a set of state transitions, and a set of transition conditions;
the control state is used to represent the control state of the driving control system, and comprises a set of state attributes;
the state transition comprises a first control state and a second control state, and is used to indicate an action of the driving control system transitioning from the first control state to the second control state;
the transition condition corresponds to the state transition, and is used to indicate the condition that needs to be satisfied for the driving control system to transition from the first control state corresponding to the state transition to the second control state corresponding to the state transition, and is a state attribute Boolean expression;
the state attribute Boolean expression is a simple Boolean expression or a compound Boolean expression formed by compounding several simple Boolean expressions through conjunction operation and/or disjunction operation;
in the state attribute Boolean expression, the simple Boolean expression is a comparison expression regarding the size of the state attribute, and the state attribute comes from the first control state of the corresponding state transition;
Step S2: creating a set of initial scenario examples by randomly generating scenario sample information, and initializing a second state transition set with a set of state transitions in the state control diagram information;
the scenario example comprises current scenario sample information; the current scenario sample information corresponds to the current scenario sample and is scenario sample information; in the initial set of scenario examples, the current scenario sample information is randomly generated scenario sample information;
Step S3: using the current scenario sample information of a scenario example in the scenario example set as the simulation data for simulating the real scenario, performing a simulation test on the driving control system program through the simulation system, and during the simulation test, collecting log output of the driving control system program and an output of the instrumentation program instruction thereof to form a sample output sequence corresponding to the scenario example; the sample output sequence is a sequence consisting of sample outputs; the sample output including a control state and a value of the corresponding state attribute;
Step S4: extracting a control state transition in the simulation result output information sequence, and removing the control state transition, as a state transition, from the second state transition set; then determining whether to end the test based on whether the second state transition set is empty as a test end condition;
Step S5: Traversing the sample outputs in the sample output sequence, if the control state of the traversed sample output is the first control state of a state transition in the second state transition set, the scenario example corresponding to the sample output sequence, the sample output and the corresponding state transition are combined into expected scenario example state transition information, thereby obtaining an expected scenario example state transition information set;
the expected scenario example state transition information comprises a scenario sample, a sample output and a state transition; the sample output is a founder result output information;
Step S6: calculating the distance between the sample output and the state transition of each expected scenario example state transition information in the expected scenario example state transition information set, and extracting the scenario example corresponding to the state transition with the smallest distance between the sample output and the state transition from the expected scenario example state transition information set to form a seed corresponding to the state transition, thereby forming a seed set; the seed comprises the state transition and the current scenario sample information; the distance between the sample output and the state transition is the distance between the state attribute Boolean expression of the transition condition corresponding to the state transition and the sample output;
Step S7: performing variation processing on the current scenario sample information of each seed in the seed set to obtain updated current scenario sample information to form a scenario example set, and then returning to step S3;
in step S6, the distance between the state attribute Boolean expression and the sample output is calculated in the following way:
for a simple Boolean expression, calculate the distance between the simple Boolean expression and the sample output;
for conjunction operation, calculate the distance for each sub-item and calculate the sum of the sub-item distances;
for the disjunction operation, calculate the distance for each sub-item and take the minimum value of the sub-item distances;
the sub-item distance is the distance between the sub-state attribute Boolean expression of the state attribute Boolean expression and the sample output;
the calculation of the distance between the simple Boolean expression and the sample output is to calculate the distance between the comparison expression regarding the size of the state attribute and the sample output, and the distance between the comparison expression F(op, sp, v) regarding hr size of the state attribute and the sample output is calculated using the following formula:
if op is equal to or not equal to, then D(F(op,sp,v))=K; otherwise D(F(op,sp,v))=K+abs(v-out(sp));
wherein op is the operator of the comparison expression regarding size, sp is the state attribute, v is the comparison value of the state attribute, F(op, sp, v) is expressed as the comparison expression regarding size: sp op v or v op sp, D(F(op, sp, v)) is the distance between the comparison expression regarding size and the sample output, K is a preset constant, abs is an absolute value function, and out(sp) is the value of the state attribute sp in the sample output.

2. The scenario testing method for a driving control system according to claim 1, **characterized in that**, in the step S8, performing variation by randomly selecting a preset variation from a preset variation list according to a table of variation selection probability.

3. The scenario testing method for a driving control system according to claim 2, **characterized in that** the scenario example further comprises seed scenario sample information and variation information; the seed scenario sample information corresponds to the seed scenario sample and is scenario sample information; the variation information is information regarding a variation of the seed scenario sample to the current scenario sample, and comprises state transition, the distance between the sample output and the state transition, probabilities corresponding to each preset variation, and the preset variation selected for the variation;
in step S2, in the initial set of scenario examples, the seed scenario sample information and the variation information are both empty;
the seed further comprises the distance between the sample output and the state transition, the original seed scenario sample information and the original seed variation information;
in step S6, when forming the seed, the seed scenario sample information and the variation information in the scenario example are used, respectively, as the original seed scenario sample information and the original seed variation information of the seed;
in step S7, when variation of the current scenario sample information is performed, first determining whether the original seed scenario sample information of the seed is empty and whether the state transition is the same as the state transition in the original seed variation information; if the original seed scenario sample information is empty or the state transition of the seed is different from the state transition in the original seed variation information, initializing the table of variation selection probability so that the selection probabilities of the preset variations in the table of variation selection probability are the same; otherwise, extracting the probabilities corresponding to the preset variations in the original seed variation information of the seed to form a table of variation selection probability, and extracting the preset variation selected for a variation in the original seed variation information of the seed as the original variation, then adjusting the probability corresponding to the original variation in the table of variation selection probability according to the comparison between the distance between the sample output and state transition of the seed and the distance between the sample output and state transition in the original seed variation information, and finally randomly selecting a preset variation from the preset variation list according to the adjusted table of variation selection probability, and performing the variation.

4. The scenario testing method for a driving control system according to claim 2, **characterized in that** the preset variations comprise: randomly changing the starting and ending points of a vehicle, randomly changing the signal light sequence, randomly changing the NPC vehicles, or adjusting the interference intensity of the NPC around the vehicle under control.

5. A scenario testing apparatus of a driving control system, the apparatus is associated with a simulation system loaded with a driving control system program; the driving control system program is instrumented with an instrumentation program instruction; the instrumentation program instruction is used to output a current control state of the driving control system and a value of the corresponding state attribute; the apparatus comprises the following modules:
a module M1 for obtaining state control diagram information;
the state control diagram information comprises a set of control states, a set of state transitions, and a set of transition conditions;
the control state is used to represent the control state of the driving control system, and comprises a set of state attributes;
the state transition comprises a first control state and a second control state, and is used to indicate an action of the driving control system transitioning from the first control state to the second control state;
the transition condition corresponds to the state transition, and is used to indicate the condition that needs to be satisfied for the driving control system to transition from the first control state corresponding to the state transition to the second control state corresponding to the state transition, and is a state attribute Boolean expression;
the state attribute Boolean expression is a simple Boolean expression or a compound Boolean expression formed by compounding several simple Boolean expressions through conjunction operation and/or disjunction operation;
in the state attribute Boolean expression, the simple Boolean expression is a comparison expression about the size of the state attribute, and the state attribute comes from the first control state of the corresponding state transition;
a module M2 for creating a set of initial scenario examples by randomly generating scenario sample information, and initializing a second state transition set with a set of state transitions in the state control diagram information;
the scenario example comprises current scenario sample information; the current scenario sample information corresponds to the current scenario sample and is scenario sample information; in the initial set of scenario examples, the current scenario sample information is randomly generated scenario sample information;
a module M3 for using the current scenario sample information of a scenario example in the scenario example set as the simulation data for simulating the real scenario, performing a simulation test on the driving control system program through the simulation system, and during the simulation test, collecting log output of the driving control system program and an output of the instrumentation program instruction thereof to form a sample output sequence corresponding to the scenario example; the sample output sequence is a sequence consisting of sample outputs; the sample output comprising a control state and a value of the corresponding state attribute;
a module M4 for extracting a control state transition in the simulation result output information sequence, and removing the control state transition, as a state transition, from the second state transition set; then determining whether to end the test based on whether the second state transition set is empty as a test end condition;
a module M5 for traversing the sample outputs in the sample output sequence, if the control state of the traversed sample output is the first control state of a state transition in the second state transition set, the scenario example corresponding to the sample output sequence, the sample output and the corresponding state transition are combined into expected scenario example state transition information, thereby obtaining an expected scenario example state transition information set;
the expected scenario example state transition information comprises a scenario sample, a sample output and a state transition; the sample output is a founder result output information;
a module M6 for calculating the distance between the sample output and the state transition of each expected scenario example state transition information in the expected scenario example state transition information set, and extracting the scenario example corresponding to the state transition with the smallest distance between the sample output and the state transition from the expected scenario example state transition information set to form a seed corresponding to the state transition, thereby forming a seed set; the seed comprises the state transition and the current scenario sample information;
the distance between the sample output and the state transition is the distance between the state attribute Boolean expression of the transition condition corresponding to the state transition and the sample output;
a module M7 for performing variation processing on the current scenario sample information of each seed in the seed set to obtain updated current scenario sample information to form a scenario example set, and then returning to the module M3;
in the module M6, the distance between the state attribute Boolean expression and the sample output is calculated in the following way:
for a simple Boolean expression, calculate the distance between the simple Boolean expression and the sample output;
for conjunction operation, calculate the distance of each sub-item and calculate the sum of the sub-item distances;
for the disjunction operation, calculate the distance for each sub-item and take the minimum value of the sub-item distances;
the sub-item distance is the distance between the sub-state attribute Boolean expression of the state attribute Boolean expression and the sample output;
the calculation of the distance between the simple Boolean expression and the sample output is to calculate the distance between the comparison expression regarding the size of the state attribute and the sample output, and the distance between the comparison expression F(op, sp, v) regarding hr size of the state attribute and the sample output is calculated using the following formula:
if op is equal to or not equal to, then D(F(op,sp,v))=K; otherwise D(F(op,sp,v))=K+abs(v-out(sp));
wherein op is the operator of the comparison expression regarding size, sp is the state attribute, v is the comparison value of the state attribute, F(op, sp, v) is expressed as the comparison expression regarding size: sp op v or v op sp, D(F(op, sp, v)) is the distance between the comparison expression regarding size and the sample output, K is a preset constant, abs is an absolute value function, and out(sp) is the value of the state attribute sp in the sample output.

6. The scenario testing apparatus of a driving control system according to claim 1, **characterized in that**, in the module M8, a preset variation is randomly selected from a preset variation list for the variation according to a table of variation selection probability.

7. The scenario testing apparatus of a driving control system according to claim 2, **characterized in that** the scenario example further comprises seed scenario sample information and variation information; the seed scenario sample information corresponds to the seed scenario sample and is scenario sample information; the variation information is information regarding a variation of the seed scenario sample to the current scenario sample, and comprises state transition, the distance between the sample output and the state transition, probabilities corresponding to each preset variation, and the preset variation selected for the variation;
in the module M2, in the initial set of scenario examples, the seed scenario sample information and the variation information are both empty;
the seed further comprises the distance between the sample output and the state transition, the original seed scenario sample information and the original seed variation information;
in the module M6, when forming the seed, the seed scenario sample information and the variation information in the scenario example are used, respectively, as the original seed scenario sample information and the original seed variation information of the seed;
in the module M7, when a variation of the current scenario sample information is performed, first determining whether the original seed scenario sample information of the seed is empty and whether the state transition is the same as the state transition in the original seed variation information; if the original seed scenario sample information is empty or the state transition of the seed is different from the state transition in the original seed variation information, initializing the table of variation selection probability so that the selection probabilities of the preset variations in the table of variation selection probability are the same; otherwise, extracting the probabilities corresponding to the preset variations in the original seed variation information of the seed to form a table of variation selection probability, and extracting the preset variation selected for a variation in the original seed variation information of the seed as the original variation, then adjusting the probability corresponding to the original variation in the table of variation selection probability according to the comparison between the distance between the sample output and state transition of the seed and the distance between the sample output and state transition in the original seed variation information, and finally randomly selecting a preset variation from the preset variation list according to the adjusted table of variation selection probability, and performing the variation.

8. The scenario testing apparatus of a driving control system according to claim 2, **characterized in that** the preset variations comprise: randomly changing the starting and ending points of a vehicle, randomly changing the signal light sequence, randomly changing the NPC vehicles, or adjusting the interference intensity of the NPC around the vehicle under control.

9. A medium, the medium stores a program instruction set readable by a machine, **characterized in that** when the program instruction set stored in the medium is read and executed by the machine, the scenario testing method of a driving control system according to any one of claims 1 to 4 can be implemented.

10. A device, the device comprises a processor and a memory; a program instruction set is stored in the memory, **characterized in that** when the program instruction set stored in the memory is loaded and executed by the processor, the scenario testing method of a driving control system according to any one of claims 1 to 4 can be implemented.
